# EUROPÄISCHE PATENTSCHRIFT

(11) **EP 3 044 878 B1**
(45) Veröffentlichungstag und Bekanntmachung des Hinweises auf die Patenterteilung: **10.07.2019**
(21) Anmeldenummer: 14747400.1
(22) Anmeldetag: 05.08.2014
(51) Int. Cl.: H03K 17/96

(54) **BETÄTIGUNGSEINRICHTUNG FÜR KRAFTFAHRZEUGE**
OPERATING DEVICE FOR MOTOR VEHICLES
DISPOSITIF D'ACTIONNEMENT DE VÉHICULES AUTOMOBILES

(30) Priorität: 12.09.2013 DE 102013110010
(43) Veröffentlichungstag der Anmeldung: 20.07.2016
(73) Patentinhaber: Huf Hülsbeck & Fürst GmbH & Co. KG, 42551 Velbert (DE)
(72) Erfinder: SCHINDLER, Mirko, 42549 Velbert (DE); VAN GASTEL, Peter, 42699 Solingen (DE); GERDES, Bernd, 45355 Essen (DE)
(74) Vertreter: Zenz Patentanwälte Partnerschaft mbB
(86) Internationale Anmeldenummer: PCT/EP2014/066846
(87) Internationale Veröffentlichungsnummer: WO 2015/036180

(56) Entgegenhaltungen:
- WO-A1-2008/131305
- US-A1- 2005 264 304
- US-A1- 2008 136 792
- US-A1- 2009 321 149

## Beschreibung

Die Erfindung betrifft eine Betätigungseinrichtung für Kraftfahrzeuge. Insbesondere betrifft die Erfindung eine Betätigungseinrichtung für die Erfassung von Annäherungen von Benutzern von Kraftfahrzeugen, wobei die Betätigungseinrichtung eine Mehrzahl von Annäherungssensoren aufweist.

Verschiedene Erfassungseinrichtungen für Benutzerzugriffe auf Kraftfahrzeuge sind bekannt. Insbesondere sind optische und kapazitive Sensoreinrichtungen bekannt, welche die Annäherung eines Benutzers oder des Körperteils eines Benutzers erfassen.

Beispielsweise beschreibt die WO2013/117386 eine Einrichtung und eine Erfassungsverfahren mit mehreren Sensorelektroden, mit deren Hilfe der Zugriff auf eine Fahrzeugklappe erfasst wird. Die dort offenbarte Sensoranordnung dient der Erfassung von Bewegungsgesten an einem Kraftfahrzeug, wobei zwei Sensorelektrodenanordnungen an räumlich versetzten Positionen am Kraftfahrzeug angeordnet sind. Die Sensorelektroden sind als längliche Elektrodenanordnungen ausgebildet und eine Steuer- und Auswerteeinrichtung erfasst die eine Änderung der Kapazität der Sensorelektrodenanordnungen erfasst. Die Steuer- und Auswerteeinrichtung ist zur Erfassung einer Zeitfolge von Kapazitätswerten jeder der Sensorelektrodenanordnungen ausgebildet. Zeitpunkte für das Ansprechen und das Abfallen jeder Sensoranordnung werden erfasst und bei Prüfung auf Betätigungserfassung von der Steuer- und Auswerteeinrichtung werden die Zeitdifferenz zwischen den Zeitpunkten des Ansprechens der Sensorelektrodenanordnungen (Ansprech-Zeitdifferenz) und die Zeitdifferenz zwischen den Zeitpunkten des Abfallens der Sensorelektroden (Abfall-Zeitdifferenz) verglichen.

Solche kapazitiven Sensoranordnungen sind an verschiedenen Stellen von Kraftfahrzeugen einsetzbar. Regelmäßig sind mit Sensorelektroden Steuer- und Auswerteschaltungen gekoppelt, die eine Änderung der Kapazität von Sensorelektroden erfassen. Beispielsweise werden die zugehörigen kapazitiven Sensorelektroden mit einer vorgegebenen Frequenz periodisch mit einer Betriebsspannung gekoppelt und es wird ein Parameter, der von der Kapazität abhängig ist, überwacht. Entsprechende Verfahren und Einrichtungen sind beispielsweise aus der US 5,730,165 bekannt.

Ein kapazitiver Sensor mit anderen Auswerteverfahren ist in der EP 1339025B1 offenbart.

Die Ausbildung der Sensorelektroden für kapazitive Sensoren kann dabei vielfältig erfolgen, beispielsweise als langgestreckte Elektroden, die im Stoßfängerbereich des Hecks angeordnet sind, um eine Fußbetätigung der Heckklappe zu erfassen (Kick-Sensor).

Andererseits sind auch andere Arten von Annäherungssensoren neben den kapazitiven Annäherungssensoren bekannt, beispielsweise solche Sensoren, die eine Veränderung des Magnetfeldes im Umwelt des Sensors erfassen.

Das Dokument WO 2008/131305 A1 offenbart einen Filmschalter für Kraftfahrzeuge, welcher einen mehrlagigen Aufbau hat und auf einer Sensorlage eine Trennlage und eine Schirmlage zur Begrenzung von sensierten Bereichen aufweist.

Aus dem Dokument US 2008/0136792 ist eine kapazitive Sensoranordnung bekannt, welche eine verbesserte Störfestigkeit gegenüber leitfähigen Flüssigkeiten aufweist. Jedes kapazitive Sensorelement ist mit einem weiteren Sensorelement gekoppelt und die Kapazität jedes Sensorelements und des gekoppelten Sensorelements wird erfasst, um unbeabsichtigte Betätigungen auszuschließen.

Das Dokument US 2005/0264304 A1 beschreibt eine Sensoreinrichtung, die eine Elektrodenanordnung in einem Muster auf einem isolierenden Substrat aufweist, wobei eine Detektionselektrode eine Masseelektrode umgreift und eine Kapazität zwischen den Elektroden bestimmt wird.

Die Anordnung und Platzierung von solchen Sensoranordnungen an einem Fahrzeug ist problematisch, denn die Sensoren sollen leicht bedienbar und erreichbar sein, ohne dass die strukturelle Integrität des Fahrzeugs oder das ästhetische Erscheinungsbild gefährdet wird.

Aufgabe der Erfindung ist es, eine kompakte und verlässliche, multifunktionale Betätigungseinrichtung zur Verfügung zu stellen, welche sich problemlos an einem Fahrzeugkörper anbringen oder in diesem integrieren lässt.

Diese Aufgabe wird erfindungsgemäß gelöst durch eine Betätigungseinrichtung mit den Merkmalen des Patentanspruchs 1.

Die erfindungsgemäße Betätigungseinrichtung weist eine Mehrzahl von Annäherungssensoren zum Erfassen einer berührungslosen Betätigung auf. Diese Annäherungssensoren können beispielsweise kapazitive Sensoren sein, jedoch auch Sensoren zur Detektion der Veränderungen in einem Magnetfeld.

Die Betätigungseinrichtung ist im Wesentlichen mit einer ebenen oder leicht gebogenen Betätigungsebene gebildet, in welcher die Sensoren zueinander beabstandet, also nebeneinander angeordnet sind. Die Erfassungsbereiche der Sensoren sind in dieselbe Raumrichtung orientiert. Die Einrichtung kann damit an einer Außenseite des Fahrzeuges mit im wesentlichen ebener Ausbildung aufgesetzt oder integriert werden.

Eine Steuer- und Auswerteschaltung ist mit den Sensoren gekoppelt, um die Signale jedes einzelnen Sensors zeitaufgelöst zu erfassen und auszuwerten. Es wird also eine Mehrzahl von Annäherungssensoren über eine Steuer- und Auswerteeinrichtung derart gekoppelt, dass die Signale der Annäherungssensoren jeweils in einer Zeitfolge erfasst werden und einer Auswertung zugeführt werden. Nur dann, wenn eine vorgegebene Abfolge oder Reihenfolge von Annäherungssignalen von den Sensoren eingeht, wird eine erfolgreiche Betätigung erkannt. Die Annäherung muss dabei entlang der Betätigungsebene ausgeführt werden, beispielsweise durch eine Wischbewegung über die Betätigungseinrichtung mit der Hand, wobei sich die Hand nacheinander den einzelnen Sensoreinrichtungen nähert und sich wieder von diesen entfernt, während sie sich über die Ebene der Erfassung hinwegbewegt.

Gemäß der Erfindung sind sämtliche Annäherungssensoren durch eine elektrisch isolierenden Kunststoffabdeckung gegenüber dem Erfassungsbereich versehen. Die Kunststoffabdeckungen sind durchlässig für elektrische und magnetische Felder. Die Erfassung der Annäherungssensoren findet durch diese Kunststoffabdeckungen hindurch statt, welche den eigentlichen Sensor von dem Erfassungsbereich trennen. Die eigentlichen Sensoren sind entsprechend von der Umgebung abgeschirmt und nicht unmittelbar zugänglich. Entsprechend werden auch Umwelteinflüsse wie Feuchtigkeit oder Schutz von den Sensoren abgehalten.

Die Kunststoffabdeckungen der einzelnen Sensoren sind getrennt ausgebildet und zwischen die leitfähigen Trenneinrichtungen eingesetzt. Auf diese Weise ist eine flachere Bauart der Sensoreinrichtung möglich.

Erfindungsgemäß ist zwischen den Sensoren, gesehen parallel zu der Erfassungsebene, auf der dem Erfassungsbereich zugewandten Seite (also auf der Außenseite bei Montage am Fahrzeug) jeweils mindestens eine elektrisch leitfähige Trenneinrichtung angeordnet. Elektrisch leitfähige Trenneinrichtungen teilen also auf der außenliegenden Seite die Sensorbereiche und deren Erfassungsbereiche voneinander ab. Als Trenneinrichtung wird hier jede leitfähige Struktur bezeichnet, die sich zwischen den Sensorelektroden, angrenzend an die Kunststoffabdeckungen erstrecken kann. Es kann also ein elektrisch leitfähiges Gerüst oder eine Gitterstruktur sein oder auch eine einzelne Leiterstruktur. Die Trenneinrichtung kann aus einer metallischen Struktur oder leitfähigen Beschichtung auf der Kunststoffabdeckungen bestehen, es können auch metallische Drähte oder verchromte Kunststoffbahnen oder verchromte Kunststoffkörper zwischen den Erfassungsbereichen ausgebildet sein.

Die Ausbildung einer solchen elektrisch leitenden Trenneinrichtung auf der außenliegenden Seite verbessert die getrennte Erfassbarkeit der einzelnen Sensorbetätigungen und der Zeitfolge der Annäherungen. Je nach Sensorart wird die Sensitivität der kapazitiven Sensoren oder auch Magnetfeldsensoren räumlich begrenzt, ein Übergreifen der sensitiven Bereiche eines Sensors auf den Bereich eines benachbarten Sensors wird verringert. Beispielsweise können Sensoren im Abstand einiger Zentimeter voneinander in einer Ebene angeordnet sein und eine verchromte Kunststoffbarriere ist zwischen dem Erfassungsbereichen angeordnet. Die metallisierte Barriere wirkt für das elektrische Feld eines kapazitiven Sensors derart als Schirmung, dass die Sensitivität auf den Bereich oberhalb des Sensors, also den Bereich der Kunststoffabdeckung des Sensors konzentriert wird. Auch für statische und niederfrequente Magnetfelder wirkt die Barriere einem Übergreifen der Sensorbereiche entgegen.

Wird nun eine Betätigung gewünscht, streicht eine Hand beispielsweise in geringer Entfernung (jedoch z.B. gänzlich ohne Berührung) über den Erfassungsbereich des ersten Sensors, dann über die leitfähige Trenneinrichtung und anschließend den Erfassungsbereich des zweiten Sensors. Die Sensoren liefern der Auswerteschaltung dann zeitlich sauber getrennte Signale dank der Trenneinrichtung. Wesentlich ist, dass die elektrisch leitfähige Trenneinrichtung als Teilung der aktiven Sensorbereiche angeordnet ist und nach außen zum Erfassungsbereich hin ausgerichtet ist.

In einer Weiterbildung der Erfindung sind drei oder mehr Annäherungssensoren vorgesehen, deren Erfassungsbereiche sämtlich durch jeweils dazwischen angeordnete Trenneinrichtungen voneinander getrennt sind. Eine solche Mehrzahl von Sensoren bietet die Möglichkeit der Überwachung komplexer Bewegungsmuster einer Betätigung durch einen Benutzer.

In einer Weiterbildung der Erfindung ist unterhalb der Trenneinrichtung eine Lichtquelle angeordnet oder ein Lichtleiter, der mit einer Lichtquelle gekoppelt ist. Eine solche Beleuchtung der elektrisch leitfähigen Trenneinrichtung ermöglicht auch bei Dunkelheit ein verlässliches Auffinden der Betätigungsbereiche und die Erkennung von deren Trennung. Beispielsweise offenbart die EP 2067665 eine Möglichkeit zur Beleuchtung einer solchen elektrisch leitfähigen Trenneinrichtung, wobei die Trenneinrichtung in Gestalt eines Herstellerlogos ausgebildet ist.

Wie vorstehend beschrieben, können als Annäherungssensoren sowohl kapazitive als auch Magnetfeldsensoren ausgebildet werden. Einerseits sind kapazitive Sensoren für den Fall einsetzbar, dass eine robuste und verlässlich flexible Auswertung gewünscht wird. Kapazitive Sensoren weisen jedoch teilweise das Problem auf, dass veränderliche Umweltbedingungen, beispielsweise Regen-, Tau- oder Schneebelag zu einer deutlichen Verschlechterung der Erfassungsleistung führen. Magnetfeldsensoren wiederum können sensibel und weniger abhängig von derartigen Umwelteinflüssen reagieren, es kann jedoch eine Trennung der Erfassungsbereiche und Begrenzung der Erfassungsbereiche problematischer sein.

Beide Sensorgestaltungen weisen also je nach Einsatzgebiet gewisse Vorteile auf und sind beide vorteilhaft mit der erfindungsgemäßen Gestaltung der Erfassungseinrichtung kombinierbar.

In einer bevorzugten Gestaltung der Erfindung wird die Abfrage der getrennten Sensorebereiche so erfolgen, dass Betätigungsschemata in der Steuer- und Auswerteeinrichtung hinterlegt sind. Die nebeneinander angeordneten Sensorbereiche können in einer zeitlichen Abfolge betätigt werden, beispielsweise in Gestalt einer Wischbewegung, Winkbewegung, Kreisbewegung oder ähnlichem und diese zeitliche Abfolge wird ausgewertet. Nur wenn die hinterlegte Betätigungsreihenfolge mit einem Betätigungsschema übereinstimmt, liefert die Steuer- und Auswerteeinrichtung ein entsprechendes Signal an eine zentrale Steuereinrichtung des Kraftfahrzeuges. Auf diese Weise können auch unterschiedliche Funktionen an ein und derselbe Betätigungseinrichtung abgerufen werden. Eine Bewegung in einer Richtung kann eine andere Funktion schalten als eine Bewegung in der entgegengesetzten Richtung.

Wesentlich an der Erfindung ist es, dass sowohl eine technische Verbesserung hinsichtlich der Trennung der Erfassungsbereiche erreicht wird, außerdem eine verbesserte Gestaltungsmöglichkeit der Betätigungseinrichtung zur Verfügung gestellt wird. Sowohl die Kunststoffabdeckung als auch die elektrisch leitfähige Trenneinrichtung können in ästhetischer Weise gestaltet werden, wobei beispielsweise durch die metallische Trenneinrichtung Teile eines Fahrzeuglogos oder Herstellerlogos nachempfunden werden. Auf diese Weise kann die Betätigungseinrichtung in das Fahrzeuglogo integriert werden und die kunststoffbedeckten Bereiche, also die Bereiche zwischen den metallischen Trenneinrichtungen, sind die aktiven Sensorflächen. Diese Einrichtung erfüllt dann sowohl einen gestalterischen Zweck als auch eine verbesserte und leicht auffindbare Betätigungseinrichtung für den Fahrzeugbenutzer. Wird ein solches Fahrzeuglogo dann außerdem noch erfindungsgemäß beleuchtet, ist in jeder Situation der Betätigungsbereich leicht aufzufinden. Da die Betätigungseinrichtung nicht mehr an verborgenen Orten installiert wird, sondern dann an prominenten Stellen am Fahrzeug platziert werden kann, ist die Bedienbarkeit verbessert. Oft sind Fahrzeuglogos genau an solchen Positionen des Fahrzeuges angeordnet, an dem eine Betätigung wünschenswert wäre, sich die Anbringen einer Sensoreinrichtung jedoch verbietet. Die Integration der Sensoreinrichtung in das Logo selbst erlaubt die Doppelfunktion und erleichtert die Bedienung.

Die Erfindung wird nun anhand eines Ausführungsbeispiels näher erläutert.
Figur 1 zeigt schematisch den Aufbau einer erfindungsgemäßen Betätigungseinrichtung, bestehend aus kapazitiven Sensorelektroden, Kunststoffabdeckungen und metallischer Trenneinrichtung;
Figur 2 zeigt schematisch die Kopplung der erfindungsgemäßen Betätigungseinrichtung mit einer Steuer- und Auswerteschaltung.

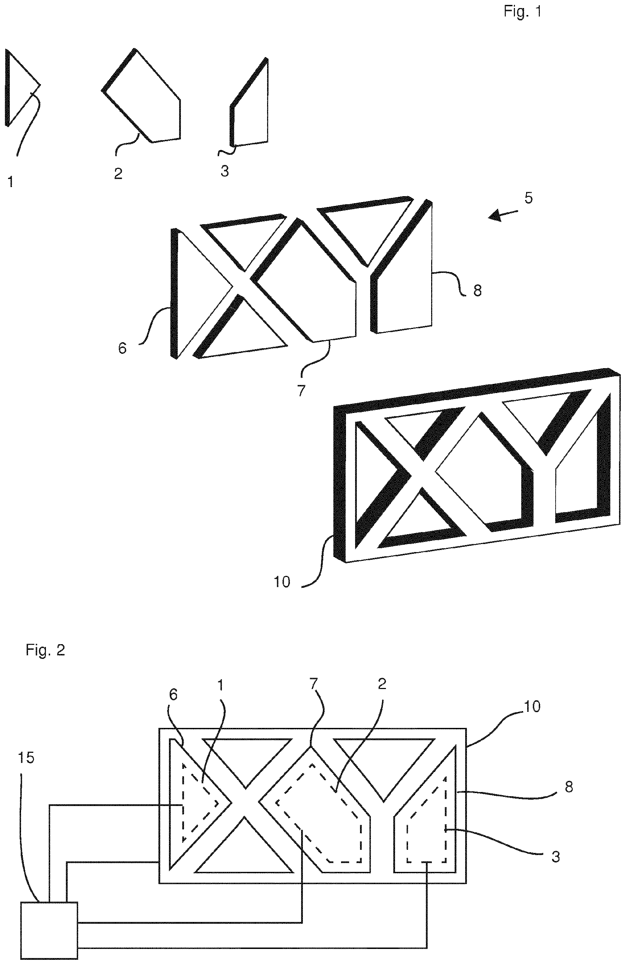

In Figur 1 sind drei unterschiedlich geformte Sensorelektrodenabschnitte 1, 2, 3 dargestellt. Diese Sensorelektroden sind aus einem metallischen Flachmaterial gebildet. Eine Mehrzahl von elektrisch isolierenden Kunststoffabdeckungen 5 ist gezeigt. Es ist erkennbar, dass die Sensorelektroden 1, 2, 3 der Formgebung der Kunststoffabdeckungen 6, 7 und 8 jeweils angepasst sind. Dabei sind die Sensorelektroden 1, 2, 3 kleiner ausgeführt, so dass jeweils Randbereiche frei bleiben, wenn die Sensorelektroden unter den Kunststoffabdeckungen angeordnet werden. Die Kunststoffabdeckungen überlappen also die Sensorelektronen an allen Seiten. Eine metallische Trenneinrichtung 10 ist in ihrer Formgebung an die Kunststoffteile 5 derart angepasst, dass die Kunststoffteile als Einlagen in die Freiräume der metallischen Abdeckung 10 wirken. Werden die Elektroden 1, 2, 3 hinter den jeweiligen Kunststoffabdeckungen 6, 7 und 8 eingesetzt, sind sie von der metallischen Trenneinrichtung 10 allseitig beabstandet. Die metallische Trenneinrichtung 10 ist in Gestalt eines Emblems eines Fahrzeugherstellers ausgestaltet, und kann im Heckbereich eines Fahrzeuges oder auch im Frontbereich anzuordnen sein.

Figur 2 zeigt die Anordnung der Komponenten zueinander in einer fertigmontierten erfindungsgemäßen Ausführungsform.

In dieser Frontansicht ist gezeigt, dass die Elektroden 1, 2, 3 in die jeweiligen getrennten Sensorbereiche angeordnet sind, wobei sie durch die Kunststoffabdeckungen 6, 7 und 8 jeweils bedeckt sind. Jede der Sensorelektroden 1, 2, 3 ist mit einer Steuer- und Auswerteeinrichtung 15 gekoppelt, welche die Kapazitätswerte jeder der Sensorelektroden zeitlich aufgelöst erfasst.

Wird nun die Hand eines Bedieners z. B. von links nach rechts über die Erfassungseinrichtung geführt, wird eine Abfolge von Kapazitätsänderungen zunächst in der Sensorelektrode 1, nachfolgend in der Sensorelektrode 2 und schließlich in der Sensorelektrode 3 detektiert. Die Trennung der Erfassungsbereiche durch die elektrisch leitende Trenneinrichtung 10 führt zu einer klaren Abgrenzung der Sensorsignale.

Es ist in diesem Beispiel außerdem dargestellt, dass die metallische Trenneinrichtung 10 ebenfalls mit der Steuer- und Auswerteschaltung gekoppelt ist, sie kann außerdem auch mit der Masse des Fahrzeuges gekoppelt sein. Eine Kopplung mit der Steuer- und Auswerteschaltung erlaubt es außerdem, eine Schirmspannung an die Trenneinrichtung 10 anzulegen, um eine noch bessere Abgrenzung der Sensorbereiche zueinander vorzunehmen.

Die Aufnahme der Annäherungssensoren in eine derart gestaltete elektrisch leitfähige Trenneinrichtung schafft eine ästhetische und prominent am Fahrzeug platzierbare Betätigungseinrichtung, welche auch ein komplexes Betätigungsverhalten des Benutzers erfassen kann.

## Patentansprüche

1. Betätigungseinrichtung für ein Kraftfahrzeug, mit einer Mehrzahl von Annäherungssensoren (1, 2, 3) zum Erfassen einer berührungslosen Betätigung, wobei die Betätigungseinrichtung sich in einer ersten Ebene erstreckt und die Annäherungssensoren (1, 2, 3) in der Ebene zueinander beabstandet angeordnet sind und mit ihren Erfassungsbereichen in dieselbe Raumrichtung orientiert sind,
wobei eine Steuer- und Auswerteeinrichtung (15) mit den Annäherungssensoren (1, 2, 3) gekoppelt ist, welche für eine zeitliche Erfassung der Sensorsignale zu jedem der Annäherungssensoren ausgebildet ist,
wobei die Annäherungssensoren mit wenigstens einer elektrisch isolierenden Kunststoffabdeckung (5) bedeckt sind und damit von dem Erfassungsbereich getrennt sind, wobei zwischen den Annäherungssensoren (1, 2, 3), orientiert zu der den Erfassungsbereichen zugewandten Seite und unmittelbar angrenzend an die Kunststoffabdeckung (5) mindestens eine elektrisch leitfähige Trenneinrichtung (10) angeordnet ist, **dadurch gekennzeichnet, dass** die Kunststoffabdeckung (5) mehrteilig ausgebildet ist und die elektrisch leitfähigen Trenneinrichtung (10) sich zwischen den Teilen (6, 7, 8) der Kunststoffabdeckung erstreckt, so dass die Teile der Kunststoffabdeckung (6, 7, 8) als Einlagen in die Freiräume der elektrisch leitfähigen Trenneinrichtung (10) ausgebildet sind.

2. Betätigungseinrichtung nach Anspruch 1, wobei wenigstens drei Annäherungssensoren (1, 2, 3) vorgesehen sind, zwischen denen jeweils Abschnitte der mindestens einen elektrisch leitfähigen Trenneinrichtung (10) angeordnet sind.

3. Betätigungseinrichtung nach einem der vorangehenden Ansprüche, wobei unterhalb der Trenneinrichtung, also auf der dem Erfassungsbereich abgewandten Seite der Trenneinrichtung wenigstens eine Lichtquelle oder ein mit einer Lichtquelle gekoppelter Lichtleiter angeordnet ist.

4. Betätigungseinrichtung nach einem der vorangehenden Ansprüche, wobei wenigstens einer der Annäherungssensoren als kapazitiver Sensor ausgebildet ist.

5. Betätigungseinrichtung nach einem der vorangehenden Ansprüche, wobei wenigstens einer der Annäherungssensoren als Magnetfeldsensor ausgebildet ist.

6. Betätigungseinrichtung nach einem der vorangehenden Ansprüche, wobei die Steuer- und Auswerteeinrichtung zur Erzeugung eines Betätigungssignals ausgebildet ist, in Abhängigkeit von einer Reihenfolge der Annäherungserkennungen von wenigstens zwei der Annäherungssensoren.

7. Betätigungseinrichtung nach einem der vorangehenden Ansprüche, wobei die Trenneinrichtung mit der Steuer- und Auswerteschaltung zum Anlegen eines vorgegebenen Potenzials, insbesondere des Massepotenzials gekoppelt ist.

## Claims

1. An operating device for a motor vehicle, with a plurality of proximity sensors (1, 2, 3) for detecting a contactless operation, wherein the operating device extends in a first plane and the proximity sensors (1, 2, 3) are arranged in the plane at a distance from each other and their detection zones are oriented in the same spatial direction, wherein a control and evaluation device (15) is coupled with the proximity sensors (1, 2, 3), said control and evaluation device (15) being designed for the time-based detection of the sensor signals for each of the proximity sensors, wherein the proximity sensors are covered by at least one electrically insulating plastic cover (5), thereby being separated from the detection zone, wherein at least one electrically conductive separator (10) is arranged between the proximity sensors (1, 2, 3), oriented toward the side facing the detection zones and immediately adjacent to the plastic cover (5), **characterized in that** the plastic cover (5) is designed in multiple parts and **in that** the electrically conductive separator (10) extends between the parts (6, 7, 8) of the plastic cover, such that the parts of the plastic cover (6, 7, 8) are designed as inserts into the open spaces of the electrically conductive separator (10).

2. The operating device according to Claim 1, wherein at least three proximity sensors (1, 2, 3) are provided and wherein sections of the at least one electrically conductive separator (10) are arranged between said sensors.

3. The operating device according to any one of the preceding claims, wherein at one light source, or an optical fiber coupled with a light source, is arranged underneath the separator, that is on the side of the separator facing away from the detection zone.

4. The operating device according to any one of the preceding claims, wherein at least one of the proximity sensors is designed as a capacitive sensor.

5. The operating device according to any one of the preceding claims, wherein at least one of the proximity sensors is designed as a magnetic field sensor.

6. The operating device according to any one of the preceding claims, wherein the control and evaluation device is designed for generating an operating signal, dependent on a sequence of proximity detections of at least two of the proximity sensors.

7. The operating device according to any one of the preceding claims, wherein the separator is coupled with the control and evaluation device for applying a defined potential, in particular a ground potential.

## Revendications

1. Dispositif d'actionnement pour un véhicule automobile, comportant une pluralité de capteurs de proximité (1,2,3) pour détecter un actionnement sans contact, dans lequel le dispositif d'actionnement s'étend dans un premier plan et les capteurs de proximité (1,2,3) sont disposés en étant espacés les uns des autres dans le plan et sont orientés avec leur zone de détection dans la même direction spatiale, dans lequel un dispositif de commande et d'évaluation (15) est couplé avec les capteurs de proximité (1,2,3), lequel est conçu pour une détection temporelle des signaux de capteur par chacun des capteurs de proximité, dans lequel les capteurs de proximité sont couverts avec au moins un couvercle en plastique électriquement isolant (5) et sont donc séparés de la zone de détection, dans lequel entre les capteurs de proximité (1,2,3), orienté par rapport au côté tourné vers les zones de détection et directement contigu au couvercle en plastique (5), au moins un dispositif de séparation électriquement conducteur (10) est disposé, **caractérisée en ce que** le couvercle en plastique (5) est configuré en plusieurs parties et le dispositif de séparation électriquement conducteur (10) s'étend entre les parties (6,7,8) du couvercle en plastique, de sorte que les parties du couvercle en plastique (6,7,8) soient conçues comme des couches superposées dans les espaces libres du dispositif de séparation électriquement conducteur (10).

2. Dispositif d'actionnement selon la revendication 1, dans lequel au moins trois capteurs de proximité (1,2,3) sont prévus, entre lesquels des portions respectives d'au moins un dispositif de séparation électriquement conducteur (10) sont disposées.

3. Dispositif d'actionnement selon une des revendications précédentes, dans lequel au-dessous du dispositif de séparation, c'est-à-dire sur le côté qui se détourne de la zone de détection du dispositif de séparation au moins une source lumineuse ou une fibre optique couplée avec une source lumineuse est disposée.

4. Dispositif d'actionnement selon une des revendications précédentes, dans lequel au moins un des capteurs de proximité est configuré comme un capteur capacitif.

5. Dispositif d'actionnement selon une des revendications précédentes, dans lequel au moins un des capteurs de proximité est configuré comme un capteur de champ magnétique.

6. Dispositif d'actionnement selon une des revendications précédentes, dans lequel le dispositif de commande d'évaluation est conçu afin de générer un signal d'actionnement, en fonction d'une séquence des reconnaissances de proximité provenant d'au moins deux des capteurs de proximité.

7. Dispositif d'actionnement selon une des revendications précédentes, dans lequel le dispositif de séparation est couplé avec le circuit de commande et d'évaluation pour appliquer un potentiel prescrit, notamment le potentiel de masse.
